# EUROPEAN PATENT SPECIFICATION

(11) **EP 2 132 834 B1**
(45) Date of publication and mention of the grant of the patent: **27.04.2016**
(21) Application number: 08782783.8
(22) Date of filing: 14.03.2008
(51) Int. Cl.: H01R 13/53, H05K 7/14

(54) **DATA CENTER NETWORK DISTRIBUTION SYSTEM**
NETZWERKVERTEILUNGSSYSTEM FÜR DATENZENTREN
SYSTEME DE DISTRIBUTION DE RESEAU DE CENTRE DE DONNEES

(30) Priority: 14.03.2007 US 894850 P
(43) Date of publication of application: 16.12.2009
(73) Proprietor: Zonit Structured Solutions, LLC, Boulder, Colorado 80301 (US)
(72) Inventor: CHAPEL, Steve, Iliff, CO 80736 (US); PACHOUD, William, Boulder, CO 80304 (US)
(74) Representative: D Young & Co LLP
(86) International application number: PCT/US2008/057154
(87) International publication number: WO 2008/113054

(56) References cited:
- WO-A1-99/57639
- WO-A1-2006/034443
- WO-A2-03/014950
- US-A1- 2004 264 112
- US-A1- 2006 139 855
- US-B2- 6 919 816

## Description

### BACKGROUND

Data centers are generally buildings that house large numbers of file servers, data processors, network switches, or other heat-generating computer components. Typically, the interior of a data center is filled with multiple rows of two or four post racks that hold electronic data processing (EDP) equipment that are arranged in parallel relation to one another throughout the data center. An aisle for service personnel may be provided between each row of racks and at ends of the rows. Each rack may house multiple, vertically spaced computer components. In this manner, a very large number of components may be placed in a data center.

The heat collectively generated by very large numbers of densely packed components within a data center may be sufficient to cause catastrophic failure of the components. Accordingly, even the earliest data centers were air conditioned twenty-four hours per day, every day of the year. As can be appreciated, cooling requirements often adds significant cost to the operation of a data center. Further, heat most often is the limiting factor in the density of components that may be placed into a data center.

In addition to temperature constraints, the amount of cabling required in data centers may be very high, due to the number of components that require network connectivity: Often, the racks in a data center are positioned on a raised floor, so that numerous cables may be run under the floor to provide connectivity to the components. Additionally or alternatively, the cables may be routed in cable trays that are positioned above the racks. Further, the racks themselves often contain multiple cables extending from them to components in other racks. The cables in a rack normally are attached to back of the mounted EDP equipment. Cabling clutter on the front or back of the mounted equipment is especially harmful to equipment cooling because the great majority of modern EDP equipment take in cooling air at the front of the cabinet and eject hot exhaust air at the rear of their chassis. The mounted data processing equipment occupies the central volume of the rack, which is normally reserved for mounted equipment. A large number of cables may restrict the ventilation in the racks and in the data center generally, which has the effect impeding the cooling of the components in the data center.

Additionally, the available space in the equipment racks may be limited. The expense of a modem data center suggests optimum utilization of that space for end-use computer equipment. The communication cabling and associated equipment (e.g., the local area network, or LAN) may be considered a data center infrastructure, similar to power and cooling. Hence, removing the LAN components from the central volume of the equipment racks reserved for EDP equipment may improve the optimization of the deployment of the end-use equipment.

It is against this background that the data center network distribution system of the present invention has been developed.

WO 2006/034443 discusses equipment rack data / power distribution.

### SUMMARY

Aspects of the invention are defined in the appended claims.

The present invention is directed to connecting rack-mounted data devices to a data network. The invention reduces the cabling required to connect such rack-mounted devices to network switches or other devices and improves the available end-use equipment space. In this manner, cabling complexity is reduced, the space required for such cabling is reduced, and improved ventilation for cooling the network devices is provided. The invention also facilitates improved connection redundancy so as to avoid or reduce the effects of failures at any connection point.

In accordance with one aspect of the present invention, an apparatus is provided for facilitating connection of rack-mounted data devices to a data network. The apparatus includes a distribution strip and a number of network ports, disposed on the distribution strip, for use in connecting the rack-mounted devices to the network. The distribution strip has a longitudinal axis and is disposed in a rack such that a length of the distribution strip, defined relative to the longitudinal axis, extends primarily or exclusively along a vertical height axis of the rack. For example, the distribution strip may be disposed in a vertical orientation in the rack. In this regard, the distribution strip may be mounted in a corner of the rack or may be integrated into the rack structure so as to improve rack ventilation and avoid using rack space in the portion of the rack used to mount electronic data processing equipment.

The network ports may be distributed along the length of the distribution strip. For example, the ports can be distributed vertically along the rack such that short patch cords can be used to connect the data devices to the distribution strip. In this regard, the apparatus may incorporate a number of patch cords for connecting the rack-mounted data devices to the network ports, wherein substantially all of the patch cords have lengths that substantially less than the height of the rack. As a further example, a majority of the patch cords may have lengths that are less than half the height of the rack or less, which reduces cabling clutter and airflow blockage. This is especially true on the back of EDP equipment where the majority of the cables are usually connected and where the cooling air is usually ejecting from the EDP equipment as exhaust air.

Additional parts may be provided along the length of the distribution strip. For example, various diagnostic or other equipment used by data center technicians, e.g., thermometers, can be plugged into other types of ports, such as USB ports, by providing ports on the distribution strip, the need to run cables for such instruments or other purposes can be reduced or substantially eliminated, thereby greatly enhancing convenience and efficiency of data center monitoring and servicing. In this regard, the distribution strip may include a "protocol gateway" that is operable to receive multiple transport protocols (e.g., USB, RS-232 serial, fiber channel, KVM, or the like) and use another transport protocol (e.g., Ethernet, TCP/IP, or other transport protocol) to encapsulate and act as a transport gateway for the received protocols. The encapsulated transport protocol (ETP) may be delivered to the desired endpoint by TCP/IP to the distribution strip that is connected to the destination originally specified by the sending gateway. The receiving gateway then de-encapsulates and transmits in native formatting the original data through the associated transport protocol (e.g., USB, RS-232, serial, Fibre Channel, etc.) to the endpoint devices. In this regard, each USB port on a strip may be connected to a virtual USB bus. This bus may be defined as a user-selected set of strip USB ports. The ports may be selected via a software application running on the strip, a computer workstation, or a dedicated device. The serial data may be encapsulated into a TCP/IP packet and then routed to all of the other USB ports in the "virtual USB bus." At the other USB ports, the data is then de-encapsulated and then directed to the USB ports on the buss and/or to a virtual USB port in a connected computer that is running the virtual USB connectivity application, which takes the incoming TCP/IP data stream and presents it to the computer running it as if it were a local USB connected port.

Each strip may further include KVM functionality as well. For example, each strip may include logic structure for executing remote KVM functionality. For example, the USB port may be used in conjunction with an Ethernet port to provide KVM functionality. The video signal from an adjacent EDP device may be captured and translated into Ethernet protocol using a suitable adapter. The mouse and keyboard may be connected from the EDP device to the distribution strip via a short, standard USB cable. Additionally, a special KVM port may be placed in each port group on the distribution strip and used with a KVM adapter that plugs into the EDP equipment's video and USB port or video and PS2 type keyboard and mouse ports.

Each strip may further include a data network switch device. For example, each strip may include logic structure for executing network connectivity logic. In addition, the apparatus may further include a network indication device, associated with each of the network ports, for providing an indication of a network association of each port. For example, an LCD or LED display associated with each port may indicate a sub-network association of the port or other information. Each strip may further include at least one fiber port for connecting the strip to the network. As used herein the term "fiber port" may include various types of network ports that use various types of protocols. For example, a fiber port may run Ethernet over copper. In one implementation, each strip includes at least two fiber ports. An associated method involves providing a distribution strip with network ports distributed along a vertical axis of a rack, and connecting each of multiple data devices in the rack to a vertically adjacent one of the network ports.

In accordance with a further aspect of the present invention, a method and apparatus ("utility") is provided for providing improved redundancy with regard to connections of rack-mounted devices to a data network. The utility involves providing a distribution strip associated with a first subset of a set of data devices, where the data devices are mounted in multiple racks, and providing first and second ports in connection with the distribution strip for connecting the strip to a network device. In this regard, the first and second ports can be used to provide separate, redundant connections to the network device for improved network connection reliability.

In accordance with a further aspect of the present invention, redundant connections are provided in relation to a number of distribution strips. An associated utility involves a first distribution strip associated with a first subset of a set of data devices, where the set of data devices are mounted in multiple racks, a second distribution strip associated with a second subset of the set of data devices, and, for each of the first and second distribution strips, first and second separate data connections to the data network. For example, the first subset of data devices may be mounted in a first rack, and the second subset of data devices may be mounted in a second rack. A variety of different topologies may be used to provide the desired redundancy. For example, for each of the distribution strips, the first and second separate data connections may extend directly to a network device of the data network. Alternatively, the first and second distribution strips may be connected in series in a loop to provide the first and second connections to one or more network devices. In the latter case, redundant connections are provided by communicating in either direction around the loop.

### BRIEF DESCRIPTION OF THE DRAWINGS

Figure 1 illustrates a block diagram of an exemplary distribution strip in accordance with an embodiment of the present invention.
Figure 2 illustrates a distribution strip in accordance with an embodiment of the present invention.
Figure 3 illustrates another distribution strip in accordance with an embodiment of the present invention.
Figure 4 illustrates a block diagram of an application for a data center network distribution system, commonly referred to as a "star topology."
Figure 5 illustrates another block diagram of an application for a data center network distribution system, commonly referred to as a "ring topology."

### DETAILED DESCRIPTION

While the invention is susceptible to various modifications and alternative forms, specific embodiments thereof have been shown by way of example in the drawings and are herein described in detail. It should be understood, however, that it is not intended to limit the invention to the particular form disclosed, but rather, the invention is to cover all modifications, equivalents, and alternatives falling within the scope of the invention as defined by the claims.

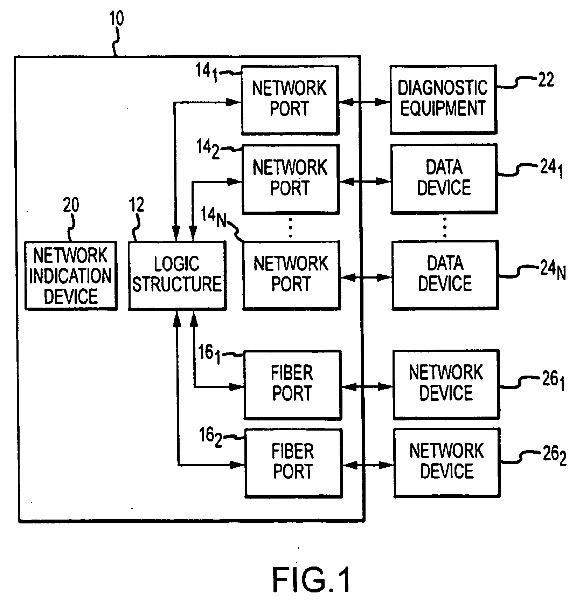

Figure 1 illustrates a block diagram of an exemplary distribution strip 10 according to one embodiment of the present invention. The distribution strip 10 may include a plurality of ports 14₁-14_{N} (wherein "N" is merely used to represent some integer greater than one, and does not necessarily indicate that the same number is being represented), positioned on the distribution strip 10, that are adapted to connect to data devices 24₁-24_{N} that may be mounted in a conventional rack or cabinet in a data center. The ports 14₁-14_{N} may be distributed along whatever vertical modulus is appropriate for the application. For example, if the strip 10 was used in a standard NEMA rack, the vertical spacing may be 1.75 inches (e.g., one rack unit or "1U"), or a multiple of 1.75 inches. The ports 14₁-14_{N} may be of multiple types for multiple purposes. For example, the ports 14₁-14_{N} may be copper Ethernet, fiber Ethernet, fiber channel, USB, other types of ports, or a combination thereof. In addition to data devices, additional equipment (e.g., diagnostic equipment 22) may be connected to the distribution strip 10. For example, thermometers, moisture sensors, video cameras, or the like may be plugged into the appropriate ports 14₁-14_{N}. Further, a USB device may be plugged into a port (e.g., the port 14₁) to provide USB connectivity to other equipment in the data center.

The distribution strip 10 may further include logic structure 12 for executing network connectivity logic (e.g., a data network switch device). The logic structure 12 may be operable to communicate with various devices connected to the ports 14₁-14_{N}. Further, the distribution strip may include two fiber ports 16₁ and 16₂ that may be operable to communicate with network devices 26₁ and 26₂. As previously described the fiber ports 16₁ and 16₂ may be any type of ports that are operable to provide communication between the network devices 26₁ and 26₂ and the strip 10 (e.g., fiber, copper, etc.)

The distribution strip 10 may also include a network indication device 20 for providing an indication of a network association for each of the ports 14₁-14_{N}. For example, the network indication device 20 may include one or more light emitting diode (LED) or liquid crystal display (LCD) modules associated with each port, and may indicate a sub-network association or other information for each port. Further, the network indication device 20 may provide status or other diagnostic information to a technician. One advantage of the present invention is that the size and number of displays are less restricted than traditional network devices because the distribution strip 10 does not occupy any rack space. Thus, the present invention may incorporate a visual display for each network port group in the distribution strip 10. The display may be adapted to display alphanumeric information, symbols, or any other image a bit-mapped dot matrix display can display. The network indication devices 20 may be used to display network logical sub-unit that a port is currently assigned to, network addresses of connected equipment, network bandwidth utilization and direction, error codes and messages, or other information that may be useful. The network indication devices 20 may be controlled in any number of ways including a manual interface, such as a push button interface, a web-integrated interface, a network management application that is operated by the user or data center personnel, or the like.

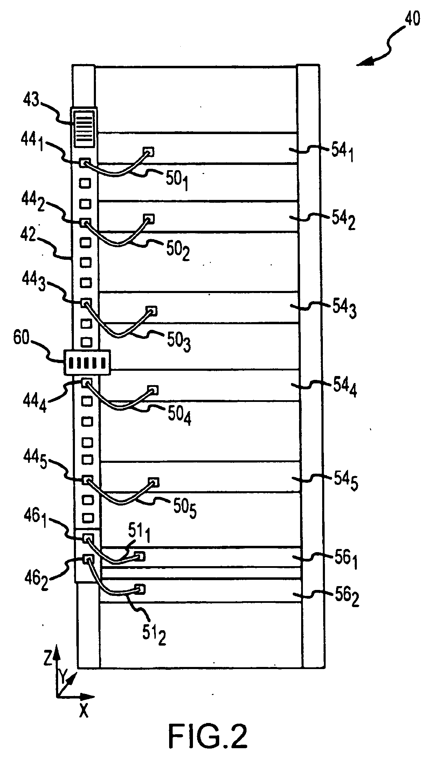

Figure 2 illustrates an application for an exemplary distribution strip 42 in accordance with an embodiment of the present invention. As shown, the distribution strip 42 may be mounted to a comer of a rack structure 40. The distribution strip 42 has a longitudinal axis and is disposed on the rack 40 such that a length of the distribution strip 42, defined relative to the longitudinal axis, extends primarily along the vertical height axis (i.e., the Z axis) of the rack 40.

The distribution strip 42 may include a plurality of ports (e.g., network or other ports 44₁-44₅) that are distributed vertically along the rack 40 such that short patch cords 50₁-50₅ may be used to connect rack-mounted data devices 54₁-54₅ to the distribution strip 42. The vertical spacing between the sets of ports may be related to an industry standard applicable to the vertical mounting dimensions in the racks of the end-use equipment. As an example, the generally accepted standard for Information Technology (IT) is the National Electrical Manufacturers Association (NEMA) standard of vertical spacing of 1.75 inches. The configuration of the distribution strip 42 permits the patch cords 54₁-54₅ to be relatively short in length. For example, the patch cords 54₁-54₅ may have lengths that are substantially less than the height of the rack 40 (e.g., less than 70% of the height, less than 50% of the height, etc...). In this regard, cabling complexity is reduced. Further, the space required for such cabling is reduced, which provides for improved ventilation for cooling the devices.

The distribution strip 42 may further include other components such as a protocol gateway 60 that may be plugged into one of the network ports or integrated into the strip 42 itself. The protocol gateway 60 may function to receive multiple data transport protocols (e.g., RS232 serial, USB, Ethernet, fiber channel, or the like) and use another data transport protocol (e.g., TCP/IP) to encapsulate and act as a transport gateway for the multiple protocols. This feature may be advantageous because one of the primary causes of the increase in the number of cables in data centers is the use of different transport protocols for different functions within the data center. Such functions may include data transport, keyboard/video/mouse (KVM) remote control systems, environmental/security monitoring (e.g., video, temperature, humidity, moisture, lights, noise, smoke, fire, etc.), or the like. By enabling multiple protocols to be transferred across a data center using a single cable, the protocol gateway 60 may reduce or eliminate the need for multiple parallel cabling systems. Further, if the endpoint destination equipment of the protocol being transported by the gateway 60 is not a piece of equipment that is near another distribution strip, it may be connected to the equipment via an adapter gateway module that functions similarly to the protocol gateway 60.

In addition to the aforementioned interface ports, the distribution strip 42 may further include a plurality of gigabit interface converter (GBIC) ports, distributed vertically along the strip 42. A GBIC is a standard for transceivers, commonly used with Gigabit Ethernet and Fibre Channel. By offering a standard, hot-swappable electrical interface, one gigabit Ethernet port may support a wide range of physical media, from copper to fiber. Hence, one of the advantages of including GBIC ports in the distribution strip 42 is the added flexibility they provide.

Other equipment that may be plugged into a network port or the protocol gateway 60, where it may then communicate with other devices on the network. For example, various diagnostic equipment may be plugged into the protocol gateway 60, or directly into one or more of the network ports. In this regard, the need to run additional cables for such instruments or other purposes may be reduced or substantially eliminated, thereby enhancing the convenience and efficiency of data center monitoring and servicing.

The protocol gateway 60 may include several features including USB virtual connectivity, Serial virtual connectivity, KVM, and other protocol gateway functionality. Each USB port on the distribution strip 42 may be connected to a virtual USB bus. This bus may be defined as a user-selected set of ports on the distribution strip 42 and other strips in the data center. These ports may be selected via a software interface on an application running on the distribution strip 42, a computer workstation, or a dedicated device, all of which have TCP/IP network connectivity between them. The software interface may be a command line interface, web interface, or a GUI running on a computer workstation.

Each USB port may be connected to a USB interface device, such as a computer USB port, a USB thermometer, USB video camera, USB door lock sensor, USB moisture sensor, etc. via a standard USB cable. The USB cable may be relatively short since the rack-mounted device will be close to a USB port on the distribution strip, reducing cable clutter.

The serial data from each USB port may be taken and encapsulated into a TCP/IP packet and then routed to all of the other USB ports in the "virtual USB bus" which can be on any other distribution strip or any computer workstation running a virtual USB connectivity application. At all other USB ports on the "virtual USB bus" the data from the first USB connected device is de-encapsulated and then directed to the USB port(s) on the bus and/or to a virtual USB port in a connected computer running the virtual USB connectivity application which takes the incoming TCP/IP data stream and presents it to the computer running it as if it were a local connected USB port.

An important feature of the invention is "bandwidth limiting." Based on the uplink speed of the data switch or the measured, inferred, or user-defined network bandwidth between the two USB endpoints, the speed mode of the USB port(s) of the distribution strip 42 will be set to be either USB mode 1.1 with a speed of 12 Mb/s or USB mode 2.0 with a speed of 480 Mb/s. This helps prevent the USB ports from oversubscribing the uplink capacity of the network switch in the distribution strip 42. The network switch may also utilize other bandwidth allocation methods to limit the amount of data traffic used by the USB virtual connectivity functionality.

The protocol gateway 60 may also provide serial virtual connectivity for RS-232, RS-422, RS-449, and RS-485 serial ports. Although only RS-232 ports are described below, all of the types listed above and any other support serial protocol will work as described for the RS-232 ports.

Each RS-232 port on the distribution strip 42 may be connected to a virtual serial connection. This connection may be and usually is point-to-point or one-to-one-with-shadow-listeners. These virtual serial connections are defined as a user-selected pairs of RS-232 ports that will listen to both of the talking ports communicate. These virtual serial ports are selected via a software interface on an application virtual serial connectivity manager running on the distribution strip 42, on a computer workstation, or a dedicated device, all of which have TCP/IP network connectivity between them. The software interface may be a command line interface, a web interface, or a traditional GUI running on a computer workstation.

Each RS-232 port is connected to a RS-232 interface device, such as a computer server RS-232 port, a RS-232 thermometer, RS-232 door lock sensor, RS-232 moisture sensor, etc., via a standard RS-232 cable. The RS-232 cable can be short since the rack mounted devices will be close to the RS-232 port of the distribution strip 42, reducing cabling clutter.

The serial data from each RS-232 port is taken and encapsulated into a TCP/IP packet and then routed to all of the other RS-232 ports in the "virtual RS-232 connection" which can be on any other distribution strip 42 or any computer workstation running a "Virtual RS-232 Connection" application. At all the other RS-232 ports on the "Virtual RS-232 Connection" the data from the first RS-232 connected device is de-encapsulated and then directed to the RS-232 ports(s) on the connection and/or to a virtual RS-232 port in a connected computer running the "Virtual RS-232 Connectivity" application which takes the incoming TCP/IP data stream and presents it to the computer running it as if it were a local RS-232 connected port. The distribution strip(s) with participating RS-232 ports and/or computer workstations or dedicated devices running the "Virtual RS-232 Connection" application will know which ports are the connected ports and which are shadow ports as set by the user via the "Virtual Serial Connectivity Manager Application." The connected ports are put in a read-write mode and the shadow ports are read-only.

Again, an important feature of our invention is bandwidth limiting. Based the uplink speed of the network switch in the distribution strip or the measured, inferred, or user-defined network bandwidth between the two serial endpoints, the speed mode of the serial port or ports on the distribution strip 42 will be set to be a value that does not oversubscribe the uplink speed of the distribution strip 42. This helps to prevent the serial ports from oversubscribing the uplink capacity of the distribution strip 42 network switch. The distribution strip 42 switch may also utilize other bandwidth allocation methods to limit the amount of data traffic used by the RS-232 Virtual Connectivity function.

The distribution strip 42 may also incorporate a keyboard, mouse, and video (KVM) functionality as follows. The video output of an electronic data processing device may be connected via an adapter to an adjacent Ethernet port on the distribution strip 42, which has been placed into KVM mode. In this mode, the KVM logic in the distribution unit 42 controls and uses the Ethernet port. The KVM logic is operable to provide the signaling that is required to maintain the KVM connection between two or more end devices. The KVM logic performs all the functions necessary to ensure that the EDP device being remotely connected does not detect that the keyboard, mouse, and video display are remote. The KVM logic also detects the video transmitted by the EDP equipment and the keyboard and mouse data received by the EDP equipment. A video to Ethernet adapter may be used to digitize the analog output (or to just input digital data for digital output video) and input it into the Ethernet port in KVM mode. The KVM logic will then take the video data and encapsulated it into a TCP/IP packet and hand that packet off to the distribution strip 42 network switch logic. This same functionality may also be done via a dedicated KVM port that is specialized for that role but combines the functions of the Ethernet virtual video port and the virtual USB connection port.

Each KVM mode Ethernet port on the distribution strip 42 may be connected to a virtual video connection between two KVM mode Ethernet ports, or a dedicated device or computer workstation running the remote KVM application. This connection may be and usually is point-to-point or one-to-one-with-shadow-listeners. These virtual video connections are defined as a user selected pairs of KVM mode Ethernet ports plus a set of KVM mode Ethernet ports that are in shadow mode and will all receive the video information. These virtual video ports are selected via a software interface on an application "virtual video connectivity manager" running on the distribution strip 42 or a computer workstation or a dedicated device, all of which have TCP/IP network connectivity between them. The software interface can be done via a command line interface, a web interface, or a traditional GUI running on a computer workstation.

The keyboard and mouse functionality is handled by using a USB Virtual Connection between a USB port on the EDP device being remotely KVM connected and mouse, a dedicated device or a computer workstation running the "Remote KVM Application". This application connects the remote USB port to the keyboard and mouse on the computer workstation in an appropriate manner so that the remote device "sees" the keyboard and mouse as being locally connected and active. It also takes the remote video feed and displays it on the computer workstation in the "Remote KVM Application" windows by de-encapsulating it from TCP/IP and handling it off to the application, which displays it. The application allows the user to select any of the remote EDP devices that are remote KVM connected and switch between them. The video for each can be displayed in a separate GUI window and the active GUI window in the application can indicate which remote EDP device is active and will receive keyboard and mouse input. This approach can be extended to multiple computer workstations (or dedicated devices) so that multiple users can connect via the remote KVM functionality to the same remote KVM EDP device. Multiple users can be active at once or one can be active and the others in "shadow" mode with no keyboard and mouse input ability. This feature is useful for collaborative work or training.

A more direct method is to use a "plugboard" approach and use the video and USB connectivity between two distribution units to connect the EDP video and USB ports to an actual remote keyboard and video monitor. The switching function between EDP devices can be done by the strip that is controlled by the user via a command line interface or a web interface. The KVM logic in each strip insures that each KVM connected EDP device "senses" a connected virtual monitor, keyboard and mouse as needed to insure normal operation.

This method can be used for PS2 style keyboard and mice, with an appropriate adapter, since PS2 is just another serial communication protocol that can easily be converted to USB.

The distribution strip 42 may also be used to gateway other protocols such as Fibre Channel, etc. The advantages of doing so are that it eliminates the need to run multiple parallel cabling systems and reduces the amount of cabling and cabling clutter in the rack. This can be achieved by encapsulating and gatewaying these protocols via TCP/IP on the data center TCP/IP network between ports on distribution units. Ports that are specific to these protocols may be provided in each network port group for that purpose and connected in point-to point or other communication topologies as are appropriate for each protocol and supportable via TCP/IP.

As discussed above in relation to Figure 1, the distribution strip 42 may also include logic structure (e.g., implemented on one or more integrated circuit boards inside the distribution strip 42) for executing network connectivity logic. Further, the distribution strip 42 may include two fiber ports 46₁ and 46₂ for connecting the distribution strip 42 to a network. As shown, the distribution strip 42 is connected to two network devices 56₁ and 56₂ through patch cables 51₁ and 51₂, respectively. In this configuration, the distribution strip 42 is connected to the two network devices 56₁ and 56₂ though separate connections, which provides redundancy and may increase the reliability of the system.

The distribution strip 42 may further include one or more network indication devices (e.g., an LCD 43) for providing a visual indication to a technician of a network association of each of the network ports and fiber ports. For example, the LCD 43 may indicate a sub-network association of the various ports. Further, the LCD 43 may indicate other status or diagnostic information to a data center technician.

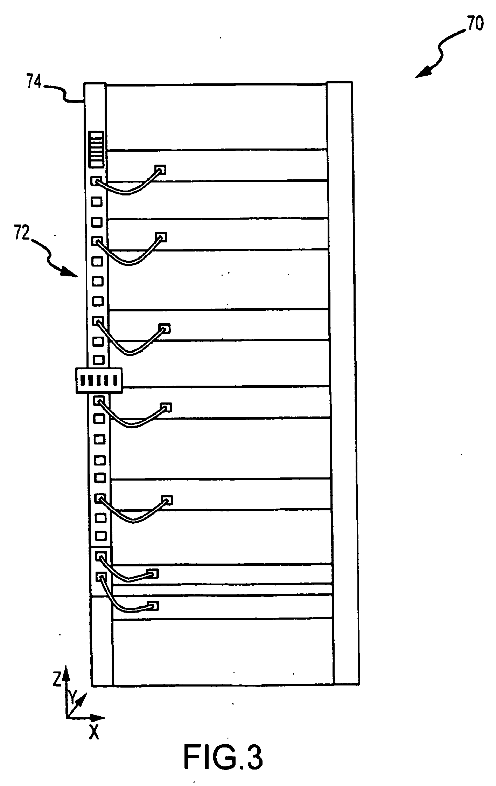

Figure 3 illustrates a data center network distribution system where a distribution strip 72 has been incorporated directly into a portion of a rack structure 70. For clarity, only those objects that differ from those shown in Figure 2 are referenced in Figure 3 and described herein. As shown, the distribution strip 72 is integrally formed into a frame 74 along one side of the rack 70. In this configuration, the space required for the distribution strip 72 is minimized because it is fit into the existing form factor of the rack 70. Further, the distribution strip 72 may be incorporated to any desirable portions of the rack 70. As can be appreciated, incorporating the distribution strip 72 into the frame of the rack 70 reduces the space required for the distribution strip 72, which provides for greater useable rack space and better cooling.

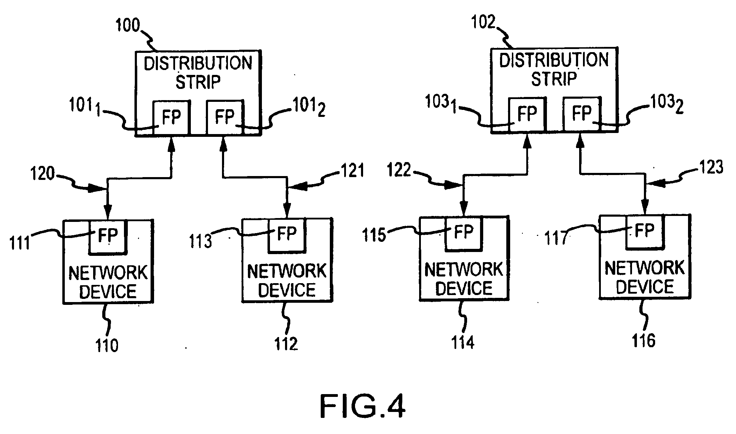

Figure 4 illustrates a block diagram of the connectivity for a data center that incorporates a data center network distribution system of the present invention to improve the redundancy with regard to rack-mounted devices. This topology may generally be referred to as a "star topology." As shown, a distribution strip 100 that is associated with a first subset of a set of data devices (e.g., the data devices 24₁-24_{N} shown in Figure 1), where the set of data devices are mounted in multiple racks, is provided and includes a first fiber port (FP) 101₁ and a second fiber port 101₂. The fiber ports 101₁ and 101₂ are connected to separate network devices 110 and 112 that include fiber ports 111 and 113 through the cables 120 and 121. Similarly, another distribution strip 102 that is associated with a second subset of a set of data devices is provided and includes first and second fiber ports 103₁ and 103₂. The fiber ports 103₁ and 103₂ are connected to separate network devices 114 and 116 that include fiber ports 115 and 117 through the cables 122 and 123. In this regard, the data devices associated with each distribution strip 100 and 102 are provided with separate, redundant connections to the network, which improves network connection reliability. It should be appreciated that each subset of data devices may be arranged in any suitable manner. For example, a first subset of data devices may be mounted in a first rack, and a second subset of data devices may be mounted in a second rack.

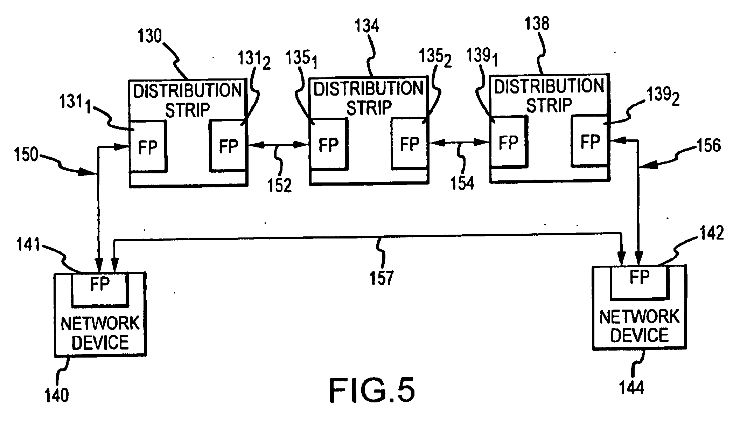

Figure 5 illustrates a block diagram of another topology that may be used to implement the data center network distribution system of the present invention. This topology may generally be referred to as a "ring topology." In this configuration a set of distribution strips 130, 134, 138 are connected in series. That is, a fiber port 135₁ of the distribution strip 134 is connected to a fiber port 131₂ of the distribution strip 130 via a cable 152, and a fiber port 135₂ of the distribution strip 134 is connected to a fiber port 139₁ of the distribution strip 138 via a cable 154. The distributions strips 130 and 138 at the "ends" of the serial connection are connected to network devices 140 and 144, respectively (via fiber ports 141 and 142), through the cables 150 and 156. The network devices 140 and 144 are coupled together via a cable 157. This allows the network devices to communicate bidirectionally, and closes the "ring." As can be appreciated, the redundant connections in this configuration are provided by communication in either direction in the chain. That is, if a break occurs at any connection point, the network connectivity will not be compromised because traffic may flow to another network device. This implementation has several advantages, including a potential reduction of the number of cables required, since patch cables are not required between every data device and a network device. Additionally, since the distribution strips 130, 134, 138 will generally be located on each side of a rack or in adjacent racks in a row of racks, the connections 152 and 154 between the distribution strips 130, 134, 138 will generally be very short, which has the effect of reducing clutter and improving ventilation for cooling the system.

The foregoing description of the present invention has been presented for purposes of illustration and description. Furthermore, the description is not intended to limit the invention to the form disclosed herein and the invention is defined by the appended claims. Consequently, variations and modifications commensurate with the above teachings, and skill and knowledge of the relevant art, can be within the scope of the present invention as claimed. The embodiments described hereinabove are further intended to explain best modes known of practicing the invention and to enable others skilled in the art to utilize the invention in such, or other embodiments and with various modifications required by the particular application(s) or use(s) of the present invention. It is intended that the appended claims be construed to include alternative embodiments to the extent permitted by the prior art.

## Claims

1. An apparatus for use in connecting rack-mounted electronic data processing devices to a data network, the apparatus comprising:
a distribution strip (42) having a longitudinal axis, said distribution strip being configured for mounting on said rack (40) such that a length of said distribution strip, defined relative to said longitudinal axis, extends primarily or exclusively along a vertical height axis of said rack; and
a plurality of network ports (14, 16, 44, 46), disposed on said distribution strip, for use in connecting said electronic data processing devices to said network,
said plurality of network ports including a first port for connecting a first protocol device to a data processing device of said network, wherein said first port supports communication between said first protocol device and said data processing device via said first port using a first data communication protocol; **characterized in that**
said distribution strip includes a protocol gateway (60) that is operable to communicate a given message between said first protocol device and said protocol gateway via said first port in accordance with said first data communication protocol thus defining a first protocol message, and communicate said given message between said protocol gateway and said data processing device in accordance with a second data communication protocol different than said first data communication protocol thus defining a second protocol message, wherein said second protocol message encapsulates said first protocol message such that said second protocol message can be de-capsulated upon receipt to retrieve said protocol message.

2. The apparatus as set forth in Claim 1, wherein said distribution strip is disposed in a vertical orientation on said rack.

3. The apparatus as set forth in Claim 1, wherein said distribution strip is incorporated into said rack.

4. The apparatus as set forth in Claim 1, wherein said network ports are distributed along said length of said distribution strip.

5. The apparatus as set forth in Claim 1, further comprising a plurality of patch cords for connecting said rack-mounted data devices to said network ports, wherein substantially all of said patch cords have lengths that are substantially less than said height of said rack.

6. The apparatus as set forth in Claim 1, further comprising a plurality of patch cords for connecting said rack-mounted data devices to said network ports, wherein a majority of said patch cords have lengths that are less than half said height of said rack.

7. The apparatus as set forth in Claim 1, wherein each distribution strip includes a data network switch device.

8. The apparatus as set forth in Claim 1, wherein said distribution strip includes logic structure for executing network connectivity logic.

9. The apparatus as set forth in Claim 1, further comprising a network indication device, associated with each of said network ports, for providing an indication of a network association or any other information regarding each of said network ports.

10. The apparatus as set forth in Claim 9, wherein said network indication device includes an LCD device.

11. The apparatus as set forth in Claim 1, wherein said network indication device includes an LED display.

12. The apparatus as set forth in Claim 1, wherein said distribution strip includes a fiber port or a copper port for connecting said strip to said network.

13. The apparatus as set forth in Claim 1, wherein said distribution strip includes at least two fiber or copper ports for use in connecting said distribution strip to said network.

14. The apparatus as set forth in Claim 1, wherein said first communication protocol includes at least two of RS-232 serial, USB, Ethernet, and Fibre Channel.

15. The apparatus as set forth in Claim 1, wherein said second data communication protocol is TCP.

16. The apparatus as set forth in Claim 1, wherein said distribution strip does not occupy any space that may be used for data processing equipment on a rack when in an installed position.

17. A method of using an apparatus for use in connecting rack-mounted electronic data processing devices to a network, in which the apparatus comprises:
a distribution strip having a longitudinal axis, said distribution strip being configured for mounting on said rack such that a length of said distribution strip defined relative to said longitudinal axis, extends primarily or exclusively along a vertical height axis of said rack;
a plurality of network ports disposed on said distribution strip, arranged to connect said electronic processing devices to said network, wherein said plurality of network ports includes a first port; for connecting a first protocol device to a data processing device of said network, wherein said first port supports communication between said first protocol device and said data processing device via said first port using a first data communication protocol; **characterized by** including
a protocol gateway in said distribution strip;
communicating a given message between said first protocol device and said protocol gateway via said first port in accordance with said first data communication protocol thus defining a first protocol message; and
communicating said given message between said protocol gateway and said data processing device in accordance with a second data communication protocol different than said first data communication protocol thus defining a second protocol message, wherein said second protocol message encapsulates said first protocol message such that said second protocol message can be de-capsulated upon receipt to retrieve said protocol message.

## Patentansprüche

1. Gerät für den Einsatz beim Verbinden von Rack-montierten elektronischen Datenverarbeitungsvorrichtungen mit einem Datennetzwerk, wobei das Gerät umfasst:
einen Verteilungsstreifen (42) mit einer Längsachse, wobei der Verteilungsstreifen zum Anbringen auf dem Rack (40) konfiguriert ist, so dass sich eine Länge des Verteilungsstreifens, welche relativ zur Längsachse definiert ist, hauptsächlich oder ausschließlich entlang einer vertikalen Höhenachse des Racks erstreckt; und
eine Mehrzahl von Netzwerkschnittstellen (14, 16, 44, 46), welche auf dem Verteilungsstreifen angeordnet sind, für den Einsatz beim Verbinden der elektronischen Datenverarbeitungsvorrichtungen mit dem Netzwerk,
wobei die Mehrzahl von Netzwerkschnittstellen eine erste Schnittstelle zum Verbinden einer ersten Protokollvorrichtung mit einer Datenverarbeitungsvorrichtung des Netzwerks umfasst, wobei die erste Schnittstelle die Kommunikation zwischen der ersten Protokollvorrichtung und der Datenverarbeitungsvorrichtung über die erste Schnittstelle unter Verwendung eines ersten Datenkommunikationsprotokolls unterstützt;
**dadurch gekennzeichnet, dass** der Verteilungsstreifen ein Protokoll-Gateway (60) umfasst, welches betreibbar ist, um eine gegebene Nachricht zwischen der ersten Protokollvorrichtung und dem Protokoll-Gateway über die erste Schnittstelle in Übereinstimmung mit dem ersten Datenkommunikationsprotokoll zu übermitteln, wodurch eine erste Protokollnachricht definiert wird, und die gegebene Nachricht zwischen dem Protokoll-Gateway und der Datenverarbeitungsvorrichtung in Übereinstimmung mit einem zweiten Datenkommunikationsprotokoll, welches verschieden zum ersten Datenkommunikationsprotokoll ist, zu übermitteln, wodurch eine zweite Protokollnachricht definiert wird, wobei die zweite Protokollnachricht die erste Protokollnachricht verkapselt in sich trägt, so dass die zweite Protokollnachricht bei Empfang entkapselt werden kann, um die Protokollnachricht zurückzuholen.

2. Gerät nach Anspruch 1, wobei der Verteilungsstreifen in einer vertikalen Ausrichtung auf dem Rack angeordnet ist.

3. Gerät nach Anspruch 1, wobei der Verteilungsstreifen im Rack integriert ist.

4. Gerät nach Anspruch 1, wobei die Netzwerkschnittstellen entlang der Länge des Verteilungsstreifens verteilt sind.

5. Gerät nach Anspruch 1, des Weiteren umfassend eine Mehrzahl von Patch-Kabeln zum Verbinden der Rack-montierten Datenvorrichtungen mit den Netzwerkschnittstellen, wobei im Wesentlichen alle Patch-Kabel Längen aufweisen, welche im Wesentlichen kürzer als die Höhe des Racks sind.

6. Gerät nach Anspruch 1, des Weiteren umfassend eine Mehrzahl von Patch-Kabeln zum Verbinden der Rack-montierten Datenvorrichtungen mit den Netzwerkschnittstellen, wobei eine Mehrzahl der Patch-Kabel Längen aufweisen, welche kürzer als die halbe Höhe des Racks sind.

7. Gerät nach Anspruch 1, wobei jeder Verteilungsstreifen eine Datennetzwerkschaltervorrichtung aufweist.

8. Gerät nach Anspruch 1, wobei der Verteilungsstreifen eine Logikstruktur zum Ausführen von Netzwerkkonnektivitätslogik umfasst.

9. Gerät nach Anspruch 1, des Weiteren umfassend eine Netzwerkanzeigevorrichtung, welche jeder Netzwerkschnittstelle beigefügt ist, zum Bereitstellen einer Anzeige einer Netzwerkverbindung oder einer beliebigen anderen Information in Bezug auf jede der Netzwerkschnittstellen.

10. Gerät nach Anspruch 9, wobei die Netzwerkanzeigevorrichtung eine LCD-Vorrichtung umfasst.

11. Gerät nach Anspruch 1, wobei die Netzwerkanzeigevorrichtung eine LED-Anzeige umfasst.

12. Gerät nach Anspruch 1, wobei der Verteilungsstreifen einen Glasfaseranschluss oder einen Kupferanschluss zum Verbinden des Streifens mit dem Netzwerk umfasst.

13. Gerät nach Anspruch 1, wobei der Verteilungsstreifen wenigstens zwei Glasfaser- oder Kupferanschlüsse für den Einsatz zum Verbinden des Verteilungsstreifens mit dem Netzwerk umfasst.

14. Gerät nach Anspruch 1, wobei das erste Kommunikationsprotokoll wenigstens zwei aus RS-232 seriell, USB, Ethernet und Fibre-Channel umfasst.

15. Gerät nach Anspruch 1, wobei das zweite Datenkommunikationsprotokoll TCP ist.

16. Gerät nach Anspruch 1, wobei der Verteilungsstreifen keinen Platz einnimmt, welcher für Datenverarbeitungsausrüstung auf einem Rack eingesetzt werden kann, wenn es sich in einer eingebauten Position befindet.

17. Verfahren zum Verwenden eines Geräts für den Einsatz beim Verbinden von Rack-montierten elektronischen Datenverarbeitungsvorrichtungen mit einem Netzwerk, wobei das Gerät umfasst:
einen Verteilungsstreifen mit einer Längsachse, wobei der Verteilungsstreifen zum Anbringen auf dem Rack konfiguriert ist, so dass sich eine Länge des Verteilungsstreifens, welche relativ zur Längsachse definiert ist, hauptsächlich oder ausschließlich entlang einer vertikalen Höhenachse des Racks erstreckt;
eine Mehrzahl von Netzwerkschnittstellen, welche auf dem Verteilungsstreifen angeordnet sind, um die elektronischen Datenverarbeitungsvorrichtungen mit dem Netzwerk zu verbinden, wobei die Mehrzahl von Netzwerkschnittstellen eine erste Schnittstelle zum Verbinden einer ersten Protokollvorrichtung mit einer Datenverarbeitungsvorrichtung des Netzwerks umfasst, wobei die erste Schnittstelle die Kommunikation zwischen der ersten Protokollvorrichtung und der Datenverarbeitungsvorrichtung über die erste Schnittstelle unter Verwendung eines ersten Datenkommunikationsprotokolls unterstützt;
**gekennzeichnet durch** Umfassen eines Protokoll-Gateways in dem Verteilungsstreifen;
Übermitteln einer gegebenen Nachricht zwischen der ersten Protokollvorrichtung und dem Protokoll-Gateway über die erste Schnittstelle in Übereinstimmung mit dem ersten Datenkommunikationsprotokoll, wodurch eine erste Protokollnachricht definiert wird; und
Übermitteln der gegebenen Nachricht zwischen dem Protokoll-Gateway und der Datenverarbeitungsvorrichtung in Übereinstimmung mit einem zweiten Datenkommunikationsprotokoll, welches verschieden zum ersten Datenkommunikationsprotokoll ist, wodurch eine zweite Protokollnachricht definiert wird, wobei die zweite Protokollnachricht die erste Protokollnachricht verkapselt in sich trägt, so dass die zweite Protokollnachricht bei Empfang entkapselt werden kann, um die Protokollnachricht zurückzuholen.

## Revendications

1. Appareil destiné à être utilisé pour connecter des dispositifs de traitement de données électroniques montés sur bâti à un réseau de données, l'appareil comprenant :
une barrette de distribution (42) ayant un axe longitudinal, ladite barrette de distribution étant configurée pour un montage sur ledit bâti (40) de sorte qu'une longueur de ladite barrette de distribution, définie par rapport au dit axe longitudinal, s'étend principalement ou exclusivement le long d'un axe de hauteur vertical dudit bâti ; et
une pluralité de ports réseau (14, 16, 44, 46), disposés sur ladite barrette de distribution, destinés à être utilisés pour connecter lesdits dispositifs de traitement de données électroniques au dit réseau,
ladite pluralité de ports réseau comportant un premier port permettant de connecter un premier dispositif de protocole à un dispositif de traitement de données dudit réseau, ledit premier port prenant en charge une communication entre ledit premier dispositif de protocole et ledit dispositif de traitement de données par l'intermédiaire dudit premier port en utilisant un premier protocole de communication de données ; **caractérisé en ce que** ladite barrette de distribution comporte une passerelle de protocole (60) qui permet de communiquer un message donné entre ledit premier dispositif de protocole et ladite passerelle de protocole par l'intermédiaire dudit premier port selon ledit premier protocole de communication de données définissant ainsi un premier message de protocole, et de communiquer ledit message donné entre ladite passerelle de protocole et ledit dispositif de traitement de données selon un deuxième protocole de communication de données différent dudit premier protocole de communication de données définissant ainsi un deuxième message de protocole, ledit deuxième message de protocole encapsulant ledit premier message de protocole de sorte que ledit deuxième message de protocole peut être désencapsulé lors de sa réception pour récupérer ledit message de protocole.

2. Appareil selon la revendication 1, dans lequel ladite barrette de distribution est disposée dans une orientation verticale sur ledit bâti.

3. Appareil selon la revendication 1, dans lequel ladite barrette de distribution est incorporée dans ledit bâti.

4. Appareil selon la revendication 1, dans lequel lesdits ports réseau sont distribués le long de ladite longueur de ladite barrette de distribution.

5. Appareil selon la revendication 1, comprenant en outre une pluralité de cordons de raccordement destinés à connecter lesdits dispositifs de données montés sur bâti auxdits ports réseau, pratiquement tous lesdits cordons de raccordement ayant des longueurs qui sont sensiblement inférieures à ladite hauteur dudit bâti.

6. Appareil selon la revendication 1, comprenant en outre une pluralité de cordons de raccordement destinés à connecter lesdits dispositifs de données montés sur bâti auxdits ports réseau, une majorité desdits cordons de raccordement ayant des longueurs qui sont inférieures à la moitié de ladite hauteur dudit bâti.

7. Appareil selon la revendication 1, dans lequel chaque barrette de distribution comprend un dispositif de commutation de réseau de données.

8. Appareil selon la revendication 1, dans lequel ladite barrette de distribution comprend une structure logique destinée à exécuter une logique de connectivité de réseau.

9. Appareil selon la revendication 1, comprenant en outre un dispositif d'indication de réseau, associé à chacun desdits ports réseau, permettant de fournir une indication d'une association réseau ou tout autre information concernant chacun desdits ports réseau.

10. Appareil selon la revendication 9, dans lequel ledit dispositif d'indication de réseau comprend un dispositif LCD.

11. Appareil selon la revendication 1, dans lequel ledit dispositif d'indication de réseau comprend un affichage LED.

12. Appareil selon la revendication 1, dans lequel ladite barrette de distribution comprend un port fibre ou un port cuivre permettant de connecter ladite barrette au dit réseau.

13. Appareil selon la revendication 1, dans lequel ladite barrette de distribution comprend au moins deux ports fibre ou cuivre destinés à être utilisés pour connecter ladite barrette de distribution au dit réseau.

14. Appareil selon la revendication 1, dans lequel ledit premier protocole de communication comprend au moins deux éléments parmi RS-232 série, USB, Ethernet, et Fibre Channel.

15. Appareil selon la revendication 1, dans lequel ledit deuxième protocole de communication de données est TCP.

16. Appareil selon la revendication 1, dans lequel ladite barrette de distribution n'occupe aucun espace qui peut être utilisé pour un équipement de traitement de données sur un bâti lorsqu'il est dans une position installée.

17. Procédé consistant à utiliser un appareil destiné à être utilisé pour connecter des dispositifs de traitement de données électroniques montés sur bâti à un réseau, l'appareil comprenant :
une barrette de distribution ayant un axe longitudinal, ladite barrette de distribution étant configurée pour un montage sur ledit bâti de sorte qu'une longueur de ladite barrette de distribution définie par rapport au dit axe longitudinal, s'étend principalement ou exclusivement le long d'un axe de hauteur vertical dudit bâti ;
une pluralité de ports réseau disposés sur ladite barrette de distribution, conçus pour connecter lesdits dispositifs de traitement électroniques au dit réseau, ladite pluralité de ports réseau comportant un premier port permettant de connecter un premier dispositif de protocole à un dispositif de traitement de données dudit réseau, ledit premier port prenant en charge une communication entre ledit premier dispositif de protocole et ledit dispositif de traitement de données par l'intermédiaire dudit premier port en utilisant un premier protocole de communication de données ; **caractérisé en ce qu'**il comporte une passerelle de protocole dans ladite barrette de distribution, définissant ainsi un premier message de protocole ; et
communiquer un message donné entre ledit premier dispositif de protocole et ladite passerelle de protocole par l'intermédiaire dudit premier port selon ledit premier protocole de communication de données ;
communiquer ledit message donné entre ladite passerelle de protocole et ledit dispositif de traitement de données selon un deuxième protocole de communication de données différent dudit premier protocole de communication de données définissant ainsi un deuxième message de protocole, ledit deuxième message de protocole encapsulant ledit premier message de protocole de sorte que ledit deuxième message de protocole peut être désencapsulé lors de sa réception pour récupérer ledit message de protocole.
